Europäisches Patentamt

European Patent Office

Office européen des brevets

(11) Publication number: **0 176 226 B1**

# EUROPEAN PATENT SPECIFICATION

(45) Date of publication of patent specification: **11.11.92** (51) Int. Cl.5: **H03K 3/033**

(21) Application number: **85305971.5**

(22) Date of filing: **22.08.85**

(54) Semiconductor circuit.

(30) Priority: **23.08.84 JP 175392/84**

(43) Date of publication of application:
**02.04.86 Bulletin 86/14**

(45) Publication of the grant of the patent:
**11.11.92 Bulletin 92/46**

(84) Designated Contracting States:
**DE FR GB**

(56) References cited:
**EP-A- 0 105 757**
**US-A- 3 601 636**
**US-A- 4 417 328**

**RADIO FERNSEHEN ELEKTRONIK, vol. 30, no. 2, 1981, pages 127-130, Berlin, DD; W. RECK-ZIEGEL: "Zeitschaltungen mit CMOS-Schaltkreisen"**

**PATENT ABSTRACTS OF JAPAN, vol. 4, no. 181 (E-37)[663], 13th December 1980; & JP-A-55 124 326 (MATSUSHITA DENKI SANGYO K.K.) 25-09-1980**

**J. Markus : "Modern Electronic Circuits Reference Manual", Mc Graw- Hill Book Company, 1980, page 608, circuit : "PWM MONO".**

**U. TIETZE, Ch. SCHENK : "Halbleiter- Schaltungstechnik", 5th edition Springer Verlag Berlin Heidelberg, New York, 1980, pages 136, 138 and 139.**

(73) Proprietor: **FUJITSU LIMITED**
**1015, Kamikodanaka Nakahara-ku**
**Kawasaki-shi Kanagawa 211(JP)**

(72) Inventor: **Suzuki, Atsushi**
**1-27, Gontazaka 1-chome Hodogaya-ku**
**Yokohama-shi Kanagawa 240(JP)**

(74) Representative: **Billington, Lawrence Emlyn et al**
**HASELTINE LAKE & CO Hazlitt House 28 Southampton Buildings Chancery Lane London WC2A 1AT(GB)**

Rank Xerox (UK) Business Services

## Description

The present invention relates to a semiconductor circuit, more particularly, to a circuit applied in, for example, a static semiconductor memory for generating a clock signal when an input signal, such as the address signal, changes.

A static memory generally does not need a clock signal, in contrast to a dynamic memory which always needs a clock signal. Some special static memories, however, use clock signals to represent address changes, write instructions, or power downs, to decrease the access time, and so forth.

In static memories using the clock signals, when a memory cell of the static memory is accessed, a bit-line pair is temporarily short-circuited to be the same potential by applying a clock signal and then is changed to a high (H) level or a low (L) level in accordance with the data stored in the memory cell. This decreases the access time in comparison with the case without using a clock signal, wherein the change is effected from the H or L state depending on the previously read stored data to the H or L state depending on the stored data which is to be currently read. This short-circuiting is also effected in a sense amplifier, wherein the response speed for currently read data is increased by resetting the output signals by the clock signal before starting the operation of the sense amplifier.

A clock signal representing a change of an input signal, such as an address signal, is conventionally generated by taking a logical OR of pulses generated by changes of respective input signals. For example, the address signals as the input signals are 10 bits in a 1K-memory, 11 bit in a 2K-memory, and so forth. From each bit of the address signals, a complementary pair of bit $\overline{A_i}$ and its inverted bit $A_i$ (i = 0, 1, 2, ...) is obtained, which are input to a decoder to act as a signal for selecting a word line or a bit line. A pulse generating circuit for each of the above-mentioned pulses is provided in an address inverter. The pulse generated from the pulse generating circuit is supplied to the OR gate for obtaining the above-mentioned logical OR.

However, the clock signal thus generated has a problem in that, when the rising time and the falling time of the input signals are indefinite, the clock width of the clock signal changes depending on the input signals. When the input signals are input address signals, this problem is caused because (1) since the address inverters and, accordingly, the above-mentioned pulse generating circuits are present over a certain area of a memory chip, the wiring lengths between each pulse generating circuit and the OR gate are different from each other, so that the timings of the output pulses reaching the OR gate are slightly different; (2) since the pulses output from the respective pulse generating circuits do not always have the same pulse widths, the pulse widths of the clock signals and the falling timings of the clock pulses are changed depending on which address signal is changed; (3) there is a case when a plurality of address signals (bits) are changed almost simultaneously but at slightly different timings, and, in this case, since the clock width is a logical sum of the plurality of pulses, the pulse width has a tendency to expand because the pulse widths generated by the respective changes of the address signals are not always the same.

It is not preferable, in order to ensure the short-circuiting of the pair of bit lines and so forth, that the clock pulse width be changed depending on which of the input signals or which of the input address signals changes. Therefore, for the above-mentioned reset of the bit line pair or of the sense amplifier, the clock signal is required to have at least a predetermined pulse width and constant falling and rising timings in response to each change of the input signals.

It is accordingly desirable to provide a semiconductor circuit which can provide a pulse with at least a constant pulse width in response to each change of input signals.

US-A-3 601 636 discloses a single-shot device having two NAND gates interconnected to provide an output pulse of fixed duration in response to an input signal, obtained using an RC delay circuit interposed between the two NAND gates. For short input pulses, the output pulse is the same length regardless of the input signal, but for longer input pulses the output pulse has at least the duration of the input pulse.

EP-A-0 105 757 by the present applicant discloses an asynchronous memory device having an address change detector which generates a clock signal of selected pulse width in response to a change in an address signal. The address change detector includes a set of pulse generators each responsive to a respective address bit, and an OR gate receiving the pulses from the pulse generators, the output of the OR gate constituting the clock signal.

J. Markus, "Modern Electronic Circuits Reference Manual", McGraw-Hill, 1980, discloses on page 680 a so-called PWM MONO circuit which provides pulse-width modulation with high-duty cycles and complementary output. The output pulse is generated from a NOR gate and lasts at least as long as a "STROBE" input signal applied to the NOR gate.

According to the present invention, there is provided a clock signal generating circuit of a semiconductor memory device, comprising:-

a plurality of pulse generating circuits each having an input for receiving an address input signal and having an output for providing a pulse in response to a change of said address input signal; and

a gate circuit having a plurality of inputs connected to the outputs of said pulse generating circuits and having an output for providing an output signal in response thereto; and characterised in that:-

said gate circuit comprises a set of inverter gates each formed by a respective input transistor and pull-up transistor whose gate terminals are both connected to an output of a respective one of said pulse generating circuits, all the pull-up transistors being connected in common to said output of said gate circuit, and all the input transistors being connected in series; and in that

a pulse-width control circuit is provided, operatively connected to the output of said gate circuit, for latching the output signal of the gate circuit and for later resetting said latching so as to extend the pulse width of the output signal to at least predetermined width; said pulse-width control circuit comprising:

a delay circuit for delaying the output signal of the gate circuit; and

a latch and reset circuit having a first transistor and a second transistor connected in series between a first power supply line and the output of said gate circuit, said first transistor being controlled in response to the output of said gate circuit, and said second transistor being controlled in response to the output of said delay circuit, and a third transistor and a fourth transistor connected in parallel between said gate circuit and a second power supply line, said third transistor being controlled in response to the output of said gate circuit, and said fourth transistor being controlled in response to the output of said delay circuit.

Thereby, the present invention can guarantee a predetermined minimum duration of an output clock signal, whilst allowing the output clock signal to be elongated in response to appropriate input signals.

Reference will now be made, by way of example, to the accompanying drawings, wherein:-

Fig. 1 is a schematic block diagram of a semiconductor memory chip for explaining the background of the present invention;

Fig. 2 is a circuit diagram of a semiconductor circuit according to an embodiment of the present invention;

Fig. 3 is a circuit diagram of a clock signal generating circuit included in the circuit shown in Fig. 2;

Figs. 4A to 4F are waveform diagrams for explaining the operation of the circuit shown in Fig. 3;

Fig. 5 is a circuit diagram illustrating an example of a pulse generating circuit included in the circuit shown in Fig. 2; and

Fig. 6 is a circuit diagram illustrating another example of a pulse generating circuit included in the circuit shown in Fig. 2.

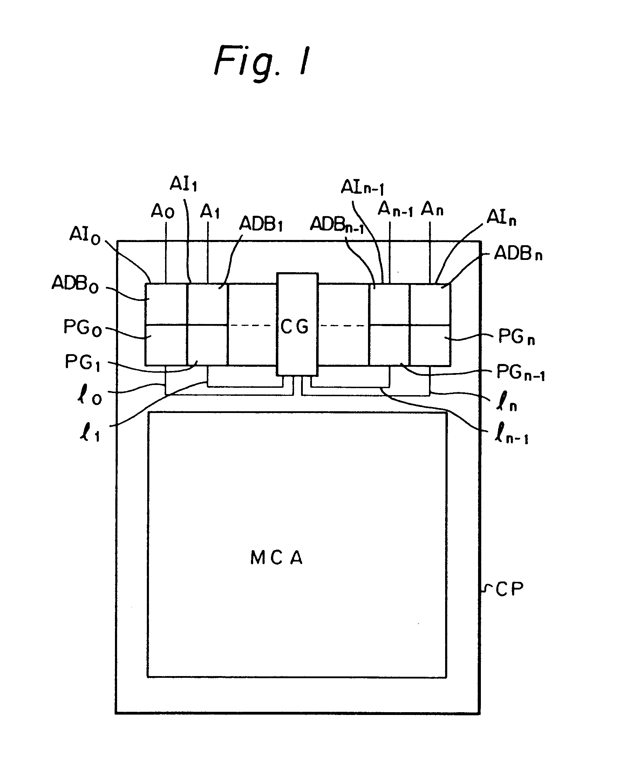

Figure 1 is a schematic plan view of a semiconductor memory chip. In Fig. 1, the semiconductor memory chip CP has a memory cell array MCA, a plurality of address inverters $AI_0$ , $AI_1$ , ..., and $AI_n$ , and a clock signal generating circuit CG. Each of the address inverters $AI_0$ , $AI_1$ , ..., and $AI_n$ consists of an address buffer circuit $ADB_i$ and a pulse generating circuit $PG_i$ , where i = 0, 1, ..., or n. The address buffer circuit $ADB_i$ receives an address signal $A_i$ to provide a waveform shaped address signal. The pulse generating circuit $PG_i$ generates a pulse in response to a change in the address signal $A_i$. The outputs of the pulse generating circuits $PG_0$ , $PG_1$ , ..., and $PG_n$ are connected through conducting lines $\ell_0$ , $\ell_1$ , ..., and $\ell_n$ to the inputs of the clock signal generating circuit CG.

Since the lengths of the conducting lines $\ell_0$ , $\ell_1$ , ..., and $\ell_n$ are different from each other, the times necessary to transfer the signals from the pulse generating circuits $PG_0$ , $PG_1$ , ..., and $PG_n$ to the clock signal generating circuit CG are slightly different from each other. This causes the problem of different timings of the generation of the clock signals output from the clock signal generating circuit, as mentioned before.

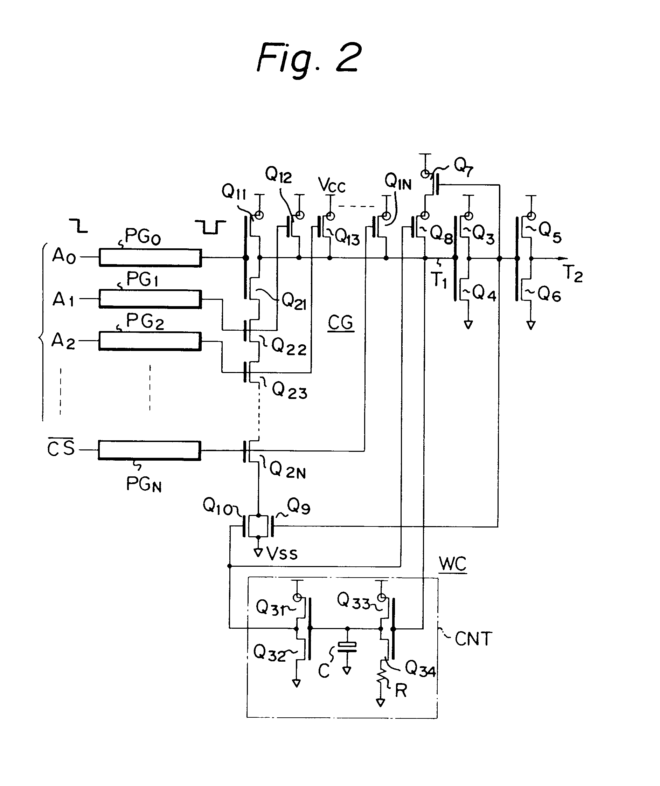

Figure 2 is a circuit diagram of a semiconductor circuit according to an embodiment of the present invention. In Fig. 2, $A_0$ , $A_1$ , $A_2$ , ... are bits of an address for accessing a static memory, and $PG_0$ , $PG_1$ , $PG_2$ , ... are pulse generating circuits provided in address inverters $AI_0$ , $AI_1$ , ... (Fig. 1) for receiving respective bits $A_0$ , $A_1$ , ... of the address. Each pulse generating circuit $PG_i$ (i = 0, 1, 2, ...) outputs a pulse having a relatively indefinite width of the low level (hereinafter referred to as L) when the corresponding bit changes from the high level (H) to L or from L to H. $PG_n$ is a pulse generating circuit which outputs a pulse when a chip select signal $\overline{CS}$ turns from the H level to the L level.

The outputs of the pulse generating circuits $PG_0$ , $PG_1$ , $PG_2$ , ..., and $PG_n$ are connected to the gate electrodes of pairs of transistors $Q_{11}$ and $Q_{21}$ , $Q_{12}$ and $Q_{22}$ , $Q_{13}$ and $Q_{23}$ , ..., and $Q_{1n}$ and $Q_{2n}$ , respectively. The pairs of transistors $Q_{11}$ and $Q_{21}$ , $Q_{12}$ and $Q_{22}$ , $Q_{13}$ and $Q_{23}$ , ..., and $Q_{1n}$ and $Q_{2n}$ each forms a complementary metal oxide semiconductor (CMOS) inverter gate. These CMOS inverter gates constitute a clock signal generating circuit CG of a NAND gate functioning as an OR gate with respect to the L level of at least one of the input signals. That is, when at least one of the pulse generating circuits $PG_0$, $PG_1$, ..., and $PG_n$ generates the pulse of the L level, the clock signal generating circuit CG outputs the H level at its output $T_1$. Since the clock signal generating circuit CG is a NAND gate, when all of the inputs are at the H level, the level of an output end $T_1$ becomes L. If at least one input is L, the level of the output end $T_1$ becomes H. Note that the transistors $Q_{11}$, $Q_{12}$, ..., and $Q_{1n}$, sources of which connected to a power supply $V_{CC}$ are illustrated by small circles in the figure, are P-channel metal oxide semiconductor (MOS) transistors; and the transistors $Q_{21}$, $Q_{22}$, ..., and $Q_{2n}$ without the small circles are N-channel MOS transistors. The N-channel MOS transistors $Q_{21}$, $Q_{22}$, ..., and $Q_{2n}$ are connected in series. There are the same number of pairs of the P-channel and N-channel MOS transistors $Q_{11}$ and $Q_{21}$, $Q_{12}$ and $Q_{22}$, ..., and $Q_{1n}$ and $Q_{2n}$ as pulse generating circuits $PG_0$, $PG_1$, ..., and $PG_n$. To the output end $T_1$, two CMOS inverter gates consisting of P-channel MOS transistors $Q_3$ and $Q_5$ and N-channel MOS transistors $Q_4$ and $Q_6$ are connected. By this, a node $T_2$ of the CMOS inverter consisting of the transistors $Q_5$ and $Q_6$ becomes an output end of the clock signal generating circuit CG. In conventional circuits, only the pulse generating circuits $PG_0$, $PG_1$, ..., and $PG_n$ and the clock signal generating circuit CG are provided, whereby a clock signal is generated from the output end $T_2$ whenever any address bit $A_0$, $A_1$, ... changes or the chip select signal $\overline{CS}$ falls. However, as mentioned before, there was a problem in that the pulse width and particularly the end time (here, the rising time) of the clock signal generated by the conventional clock signal generating circuit are not always constant.

The generating timings (here, the falling timings) of the clock signals of the pulse generating circuits $PG_1$, $PG_2$, ... are relatively constant. The fluctuations occur in the end timings (here, the rising timings). Because of these fluctuations, the pulse width of the output clock signal was not always constant.

In the present invention, the clock signal generating circuit CG is provided with a circuit WC for making the output pulse width constant. The circuit WC consists of a latch and reset circuit, constructed by P-channel MOS transistors $Q_7$ and $Q_8$ connected in series between the power supply $V_{CC}$ and the output end $T_1$ of the NAND gate and N-channel MOS transistors $Q_9$ and $Q_{10}$ connected in parallel between the source of the transistor $Q_{2n}$ and the ground power supply $V_{SS}$, and a control circuit CNT, constructed by P-channel MOS transistors $Q_{31}$ and $Q_{33}$, N-channel MOS transistors $Q_{32}$ and $Q_{34}$, a resistor R, and a MOS capacitor C forming an RC delay circuit, as shown in Fig. 2.

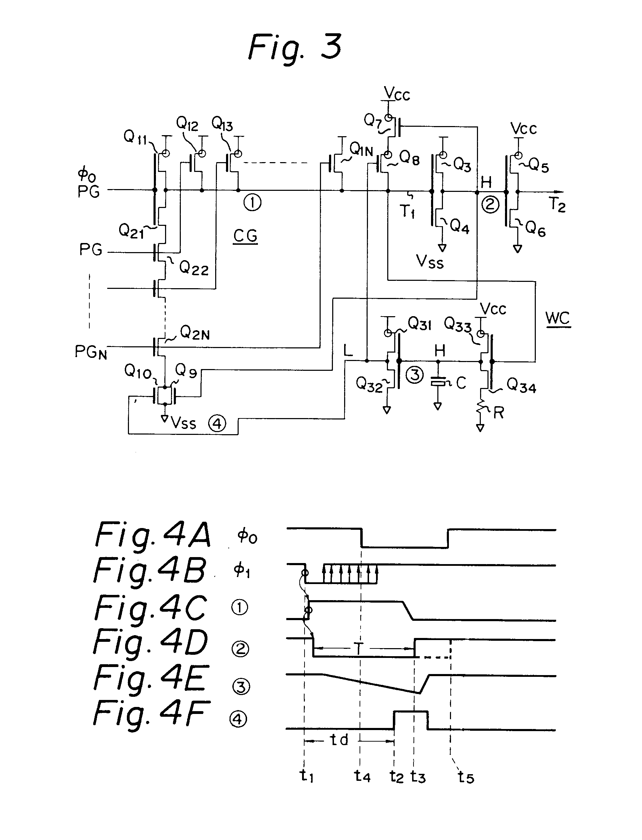

Figure 3 is a circuit diagram of the clock signal generating circuit CG and the circuit WC included in the circuit shown in Fig. 2.

Referring to Fig. 3, in the latch and reset circuit formed by the P-channel MOS transistors $Q_7$ and $Q_8$ and the N-channel MOS transistors $Q_9$ and $Q_{10}$, the gate of the transistor $Q_7$ is connected to the output end of the inverter formed by the transistors $Q_3$ and $Q_4$; the gate of the transistor $Q_8$ is connected to the output end of the control circuit CNT; the gate of the transistor $Q_9$ is connected to the output end of the CMOS inverter formed by the transistors $Q_3$ and $Q_4$; and the gate of the transistor $Q_{10}$ is connected to the output end of the control circuit CNT. In the control circuit CNT, the transistors $Q_{33}$ and $Q_{34}$ form one CMOS inverter, and the transistors $Q_{31}$ and $Q_{32}$ form another. The gates of the transistors $Q_{33}$ and $Q_{34}$ function as an input end of the control circuit CNT and are connected to the output end $T_1$ of the NAND gate. The output of the CMOS inverter formed by the transistors $Q_{33}$ and $Q_{34}$ is connected to the gates of the transistors $Q_{31}$ and $Q_{32}$. The source of the transistor $Q_{34}$ is connected through the resistor R to the ground power supply $V_{SS}$. Between the output of the CMOS inverter formed by the transistor $Q_{33}$ and $Q_{34}$ and the ground power supply $V_{SS}$, the CMOS capacitor C is connected. The output of the CMOS inverter formed by the transistors $Q_{31}$ and $Q_{32}$ functions as the output of the control circuit CNT.

Figures 4A through 4F show the potential changes in respective portions in the circuit shown in Fig. 3. In Figs. 4A-4F, $\phi_0$ and $\phi_1$ represent pulses generated by the pulse generating circuits $PG_0$ and $PG_1$; and ①, ②, ③, and ④ represent potential changes of the nodes ①, ②, ③, and ④ in the circuit shown in Fig. 3.

The operation of the circuit shown in Fig. 3 is described with reference to Figs. 4A to 4F. In a state when no change occurs in any address bit or the chip select bit $\overline{CS}$, the output signals $\phi_0$, $\phi_1$, ... of the all pulse generating circuits $PG_0$, $PG_1$, ... and $PG_n$ are at the H level so that, as illustrated in Fig. 3 and in Fig. 4C, the node $T_1$ is L; the output ② of the inverter formed by the transistors $Q_3$ and $Q_4$ is H, as shown in Fig. 4D; and, accordingly, the transistor $Q_7$ is OFF; the transistor $Q_9$ is ON; the output ③ of the CMOS inverter formed by the transistors $Q_{33}$ and $Q_{34}$ is H, as shown in Fig. 4E; the capacitor C is charged to $V_{CC}$; the output ④ of the inverter formed by the transistors $Q_{31}$ and $Q_{32}$ is L, as shown in Fig. 4F; and, accordingly, the transistor $Q_8$ is ON and the transistor $Q_{10}$ is OFF. In the transistors $Q_7$ and $Q_8$, since the transistor $Q_7$ is OFF, the node $T_1$ is not pulled up to $V_{CC}$. Also, in the transistors $Q_9$ and $Q_{10}$, since the

transistor $Q_9$ is ON, the transistors $Q_{21}$, $Q_{22}$, ... and $Q_{2n}$ connected in series in the NAND gate are connected through the transistor $Q_9$ to a ground power supply $V_{SS}$.

In this state, when either of the address bits, for example, $A_1$, is changed so that a pulse $\phi_1$ falls from H to L at a time $t_1$ as illustrated in Fig. 4B, the NAND gate generates H so that node $T_1$ becomes H as shown in Fig. 4C, and the output ② of the inverter formed by the transistors $Q_3$ and $Q_4$ becomes L. Therefore, the P-channel transistor $Q_7$ turns ON so that the node $T_1$ is pulled up to $V_{CC}$ by the transistors $Q_7$ and $Q_8$; and the transistor $Q_9$ turns OFF so that the source of the transistor $Q_{2n}$ is inhibited from being pulled down to $V_{SS}$. Thus, the node ② of the clock signal generating circuit CG is latched to L; and, accordingly, the output end $T_2$ is latched to H. In this state also, the output ③ of the inverter formed by the transistors $Q_{33}$ and $Q_{34}$ gradually decreases to L; and the output ④ of the inverter formed by the transistors $Q_{31}$ and $Q_{32}$ becomes H at a time $t_2$ when the level at the node ③ becomes lower than the threshold voltage of the P-channel transistor $Q_{31}$. Since the RC delay circuit formed by the resistor R and the capacitor C is inserted, the change of the level at the nodes ④ includes the time delay td. When the output 4 of the inverter formed by the transistors $Q_{31}$ and $Q_{32}$ becomes H after this delay, the P-channel transistor $Q_8$ turns OFF at a time $t_3$ so that the above-mentioned pulling up of the node $T_1$ is stopped, i.e. the latch is released; and the N-channel transistor $Q_{10}$ turns ON in response to the H level at the node 4 so that the transistors $Q_{21}$, $Q_{22}$, ... and $Q_{2n}$ connected in series are connected through the transistor $Q_{10}$ to $V_{SS}$. Accordingly, as long as the pulses from the pulse generating circuits are not present, i.e. under the condition that all of the output signals $\phi_0$, $\phi_1$, ... output from the pulse generating circuits $PG_0$, $PG_1$, ..., and $PG_n$ are at the H level, the node $T_1$ is pulled down to $V_{SS}$ (L level) and, therefore, the node 2 is raised to the H level at the time $t_3$ as shown in Fig. 4D. Thus, the output clock width of the clock signal generating circuit CG becomes a constant value determined by the RC time constant. Even when there are differences in the reset timings of the pulse $\phi_1$, as illustrated by arrows in Fig. 4B, the output clock pulse at the node 2 has a constant pulse width T.

There is a possibility of generation of two or more pulses output at slightly different timings from the pulse generating circuits $PG_0$, $PG_1$, ... and $PG_n$. As an example, Figs. 4A and 4B show the two pulses $\phi_0$ and $\phi_1$ generated at different timings $t_1$ and $t_4$ from the pulse generating circuits $PG_0$ and $PG_1$. In this case, the pulse width of the pulse at the node 2 is elongated to greater than the predetermined minimum value T, and terminates at a

time $t_5$. The time $t_5$, hence the duration of the output clock pulse in this case, is determined by the reset timing of $\phi_0$. Fig. 4D shows the elongated output clock pulse by a dashed line.

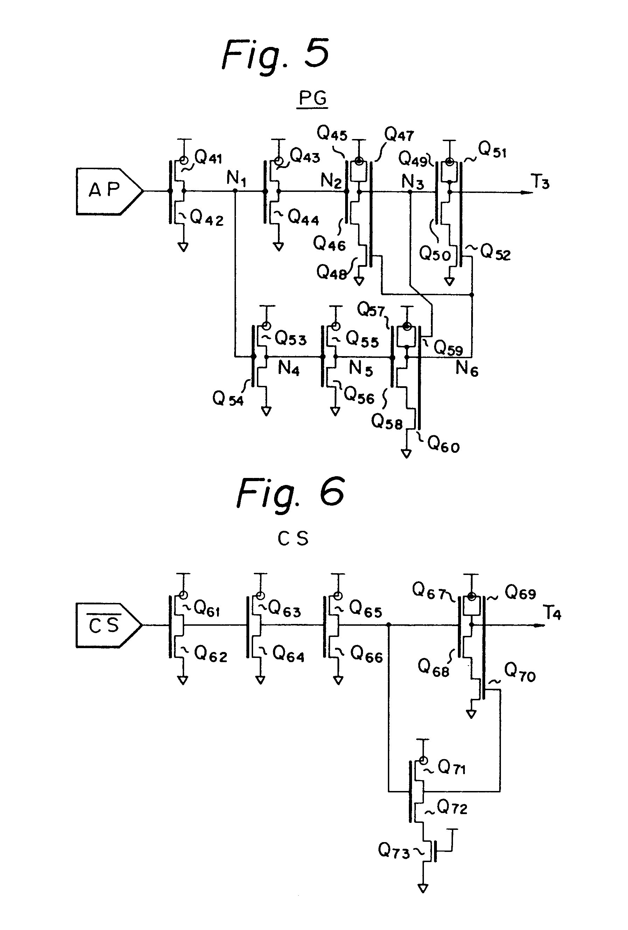

Fig. 5 shows an example of one of the pulse generating circuits $PG_0$, $PG_1$, ..., except for the circuit $PG_n$. In Fig. 5, AP is an input pad to which one of the address bits $A_0$, $A_1$, $A_2$, ... is applied; $Q_{41}$, $Q_{43}$, $Q_{45}$, $Q_{47}$, $Q_{49}$, $Q_{51}$, $Q_{53}$, $Q_{55}$, $Q_{57}$, and $Q_{59}$ are P-channel MOS transistors; and $Q_{42}$, $Q_{44}$, $Q_{46}$, $Q_{48}$, $Q_{50}$, $Q_{52}$, $Q_{54}$, $Q_{56}$, $Q_{58}$, and $Q_{60}$ are N-channel MOS transistors. Pairs of transistors $Q_{41}$ and $Q_{42}$, $Q_{43}$ and $Q_{44}$, $Q_{53}$ and $Q_{54}$, and $Q_{55}$ and $Q_{56}$, constitute CMOS inverters, respectively. Groups of transistors $Q_{45}$, $Q_{46}$, $Q_{47}$ and $Q_{48}$, $Q_{49}$, $Q_{50}$, $Q_{51}$ and $Q_{52}$, and $Q_{57}$, $Q_{58}$, $Q_{59}$ and $Q_{60}$ constitute CMOS NAND gates, respectively.

The mutual conductances gm of the transistors $Q_{46}$, $Q_{48}$, $Q_{58}$ and $Q_{60}$ are made to be relatively small. On the contrary, the mutual conductances gm of the transistors $Q_{50}$ and $Q_{52}$ are made to be relatively large. Since the mutual conductances gm of the transistors $Q_{50}$ and $Q_{52}$ are relatively large, the output pulse $\phi$ at the node $T_3$ falls rapidly in response to a change of an address bit applied to the input pad AP. Also, since the mutual conductances gm of the transistors $Q_{46}$, $Q_{48}$, $Q_{58}$ and $Q_{60}$ are relatively small, the output pulse $\phi$ at the node $N_3$ rises a predetermined time later from the change of the address bit applied to the input pad AP.

In more detail, for example, when the potential at the input pad AP is at H, then the node $N_1$ is L; the node $N_2$ is H; the transistor $Q_{46}$ is ON; the node $N_4$ is H; the node $N_5$ is L; the node $N_6$ is H; the transistor $Q_{48}$ is ON; and, accordingly, the node $N_3$ is L and the output end $T_3$ is H. In this state, the node $N_4$ is H; the node $N_5$ is L; and the node $N_6$ is H; and the transistor $Q_{52}$ is ON. From this state, when the address bit applied to the input pad AP turns to L, then the node $N_1$ becomes H; the node $N_2$ becomes L; the node $N_3$ becomes H; and the transistor $Q_{50}$ turns ON. Because of its large gm, the output end $T_3$ rapidly turns to the L level. Also, the node $N_4$ turns to L, and the node $N_5$ turns to H. The transistors $Q_{58}$ and $Q_{60}$ turn ON in response to the H levels at the nodes $N_5$ and $N_3$, respectively. However, since the mutual conductances of the transistors $Q_{58}$ and $Q_{60}$ are relatively small, the node $N_6$ gradually turns to the L level. Therefore, in response to the rapid operation of the transistor $Q_{50}$, the output end $T_3$ rapidly turns to the L level in response to a fall of the applied address bit. When the transistors $Q_{58}$ and $Q_{60}$ turn ON, the node $N_6$ gradually turns to the L level so that the transistor $Q_{52}$ becomes OFF. Thus, a predetermined time later from the fall of the address bit, the output end $T_3$ rises again to the H level. The pulse width of the pulse obtained at the output end $T_3$ of the pulse generating circuit PG is determined by the values of the mutual conductances gm of the transistors $Q_{50}$, $Q_{52}$, $Q_{58}$, and $Q_{60}$.

Similarly, when the potential at the input pad AP changes from L to H, a pulse having a pulse width corresponding to the difference in the mutual conductances gm of the transistors $Q_{50}$, $Q_{52}$ and $Q_{46}$, $Q_{48}$ is output at the output end $T_3$.

Since the mutual conductances gm of the transistors can not be determined accurately in the manufacturing process, the pulse width of the pulse at the output end $T_3$ is relatively indefinite because the rising time is indefinite. Therefore, as illustrated in Fig. 4B by the arrows, the end of the pulse $\phi_1$ is indefinite. This is the reason why the pulse generating circuit CG including the circuit WC as shown in Fig. 2 is necessary. By the circuit shown in Fig. 2, a constant pulse width can be obtained regardless of the pulse widths applied from the pulse generating circuits $PG_0$, $PG_1$, ..., and $PG_n$.

Figure 6 is a circuit diagram showing an example of the pulse generating circuit $PG_n$ shown in Fig. 2. In Fig. 6, the circuit $PG_n$ includes pairs of P-channel and N-channel transistors $Q_{61}$ and $Q_{62}$, $Q_{63}$ and $Q_{64}$, $Q_{65}$ and $Q_{66}$, and $Q_{71}$ and $Q_{72}$ which respectively constitute CMOS inverters. $Q_{69}$ is a P-channel transistor, and $Q_{70}$ and $Q_{73}$ are N-channel transistors. $Q_{67}$, $Q_{68}$, $Q_{69}$ and $Q_{70}$ constitute a CMOS NAND gate. This circuit $PG_n$ also generates a pulse at an output end $T_4$ in response to a change from H to L of the chip select signal $\overline{CS}$.

The pulse generating circuits $PG_0$, $PG_1$, ..., and $PG_n$ are not restricted to those for receiving the address bits $A_0$, $A_1$, $A_2$, ... or the chip select signal $\overline{CS}$. For example, a static random-access memory (RAM) is known in which a predetermined time after an address change, the selected word line is turned to the nonselected state (L level) so as to save power. In this case, when a write instruction is applied, the above-mentioned selected word line must be set to the H level during a necessary time. To do this, the pulse generating circuit must generate a pulse in response to a write enable signal $\overline{WE}$.

The clock signal generating circuit CG is not restricted to the circuit shown in Fig. 2. Various variations are possible within the scope of the present invention. For example, the number of the CMOS inverters in the clock signal generating circuit may be arbitrarily selected in accordance with the desired output. If a pulse of H level is necessary, an additional inverter may be added. Is a clock signal must be generated in response to a change from L to H of an input signal, this is also possible to those skilled in the art based on the circuit shown in Fig. 2. Further, in place of connecting the node $T_1$ to the gates of the transistors $Q_{33}$ and $Q_{34}$, the output of the inverter formed by the transistors $Q_3$ and $Q_4$ may be connected through an additional CMOS inverter to the gates of the transistors $Q_{33}$ and $Q_{34}$, or the output end $T_2$ may be connected to the gates of the transistors $Q_{33}$ and $Q_{34}$. Still further, in place of the output end $T_2$, the output of the CMOS inverter formed by the transistors $Q_3$ and $Q_4$ may be used as the output end of the clock signal generating circuit CG.

## Claims

1. A clock signal generating circuit of a semiconductor memory device, comprising:-

    a plurality of pulse generating circuits ($PG_0$, $PG_1$, ...) each having an input for receiving an address input signal and having an output for providing a pulse in response to a change of said address input signal; and

    a gate circuit (CG) having a plurality of inputs connected to the outputs of said pulse generating circuits ($PG_0$, $PG_1$, ...) and having an output for providing an output signal in response thereto; characterised in that:-

    said gate circuit (CG) comprises a set of inverter gates ($Q_{11}$, $Q_{21}$; $Q_{12}$, $Q_{22}$;...$Q_{1N}$, $Q_{2N}$) each formed by a respective input transistor ($Q_{21}$, $Q_{22}$,...$Q_{2N}$) and pull-up transistor ($Q_{11}$, $Q_{12}$,...$Q_{1N}$) whose gate terminals are both connected to an output of a respective one of said pulse generating circuits ($PG_0$, $PG_1$,...), all the pull-up transistors being connected in common to said output of said gate circuit, and all the input transistors being connected in series; and in that

    a pulse-width control circuit (WC) is provided, operatively connected to the output of said gate circuit (CG), for latching the output signal of the gate circuit and for later resetting said latching so as to extend the pulse width of the output signal to at least a predetermined width; said pulse-width control circuit (WC) comprising:

    a delay circuit for delaying the output signal of the gate circuit (CG); and

    a latch and reset circuit ($Q_7$ ...$Q_{10}$) having a first transistor ($Q_7$) and a second transistor ($Q_8$) connected in series between a first power supply line ($V_{cc}$) and the output of said gate circuit, said first transistor being controlled in response to the output of said gate circuit (CG), and said second transistor ($Q_8$) being controlled in response to the output of said delay circuit, and a third transistor ($Q_9$) and a fourth transistor ($Q_{10}$) connected in parallel be-

tween said gate circuit and a second power supply line, said third transistor being controlled in response to the output of said gate circuit, and said fourth transistor being controlled in response to the output of said delay circuit.

2. A circuit as set forth in claim 1, wherein said pulse-width control circuit (WC) further comprises:-

a control circuit (CNT) having an input end responsive to said output of said gate circuit (CG) and having an output end connected to said latch and reset circuit ($Q_9$, $Q_{10}$), said control circuit (CNT) including said delay circuit for transferring a signal change at said input end to said output end with a predetermined time delay.

3. A circuit as set forth in claim 2, further comprising an inverter ($Q_3$, $Q_4$) having an input end, connected to said output of said gate circuit (CG), and an output end, connected to a gate electrode of said first transistor ($Q_7$), and wherein said second transistor ($Q_8$) has a gate electrode connected to said output end of said control circuit (CNT), said first and second transistors being connected in series between a power supply and said output of said gate circuit (CG).

4. A circuit as set forth in claim 3, wherein said third transistor ($Q_9$) has a gate electrode connected to said output end of said inverter ($Q_3$, $Q_4$) and said fourth transistor ($Q_{10}$) has a gate electrode connected to said output end of said control circuit (CNT), said third and fourth transistors being connected between said gate circuit (CG) and a ground power supply.

5. A circuit as set forth in claim 4, wherein said control circuit (CNT) comprises:-

a first inverter ($Q_{33}$, $Q_{34}$) having an input end connected to said output of said gate circuit (CG);

a second inverter ($Q_{31}$, $Q_{32}$) having an input end connected to the output end of said first inverter ($Q_{33}$, $Q_{34}$) and having an output end connected to the gate electrodes of said second transistor ($Q_8$) and said fourth transistor ($Q_{10}$);

a resistor (R) connected between said first inverter ($Q_{33}$, $Q_{34}$) and the ground power supply; and

a capacitor (C) connected between the output end of said first inverter ($Q_{33}$, $Q_{34}$) and the ground power supply;

said resistor (R) and said capacitor (C) forming said delay circuit.

6. A circuit as set forth in any one of claims 1 to 5, further comprising an additional pulse-generating circuit ($PG_N$) arranged to receive a chip select signal ($\overline{CS}$) for selecting said memory device.

7. A circuit as set forth in any one of claims 1 to 5, further comprising an additional pulse-generating circuit ($PG_N$) arranged to receive a write enable signal for enabling a write operation of said memory device.

8. A circuit as set forth in any preceding claim, wherein said clock signal is used for short-circuiting pairs of bit lines in said memory device.

**Patentansprüche**

1. Eine Taktsignalgeneratorschaltung einer Halbleiterspeichervorrichtung mit:

einer Vielzahl von Impulsgeneratorschaltungen ($PG_0$, $PG_1$, ...), von denen jede einen Eingang für den Empfang eines Adreßeingangssignals und einen Ausgang für die Lieferung eines Impulses als Reaktion auf eine Änderung des genannten Adreßeingangssignals hat; und

einer Gatterschaltung (CG) mit einer Vielzahl von Eingängen, die mit den Ausgängen der genannten Impulsgeneratorschaltungen ($PG_0$, $PG_1$, ...) verbunden sind, und mit einem Ausgang für die Lieferung eines Ausgangssignals als Reaktion darauf; dadurch gekennzeichnet, daß

die genannte Gatterschaltung (CG) einen Satz von Invertergattern ($Q_{11}$, $Q_{21}$; $Q_{12}$, $Q_{22}$; ... $Q_{1N}$, $Q_{2N}$) umfaßt, jedes gebildet durch einen entsprechenden Eingangstransistor ($Q_{21}$, $Q_{22}$, ... $Q_{2N}$) und Pull-up-Transistor ($Q_{11}$, $Q_{12}$, ... $Q_{1N}$), deren Gateanschlüsse beide mit einem Ausgang von jeweils einer der genannten Impulsgeneratorschaltungen ($PG_0$, $PG_1$, ...) verbunden sind, wobei alle Pull-up-Transistoren gemeinsam mit dem genannten Ausgang der genannten Gatterschaltung verbunden sind und alle Eingangstransistoren in Reihe geschaltet sind; und dadurch gekennzeichnet, daß

ein Impulsbreitensteuerschaltung (WC) vorgesehen ist, operativ verbunden mit dem Ausgang der genannten Gatterschaltung (CG), zum Halten des Ausgangssignals der Gatterschaltung und zum späteren Rücksetzen des genannten Haltens, um so die Impulsbreite des Ausgangssignals auf zumindest die vorher festgesetzte Breite zu erweitern; wobei der genannte Impulsbreitensteuerschaltung (WC) folgendes umfaßt:

eine Verzögerungsschaltung zum Verzögern des Ausgangssignals der Gatterschaltung (CG); und

eine Halte- und Rücksetzschaltung (Q$_7$ ... Q$_{10}$) mit einem ersten Transistor (Q$_7$) und einem zweiten Transistor (Q$_8$), in Reihe geschaltet zwischen einer ersten Stromversorgungsleitung (V$_{CC}$) und dem Ausgang der genannten Gatterschaltung, wobei der genannte erste Transistor als Reaktion auf den Ausgang der genannten Gatterschaltung (CG) gesteuert wird und der genannte zweite Transistor (Q8) als Reaktion auf den Ausgang der genannten Verzögerungsschaltung gesteuert wird, und einem dritten Transistor (Q$_9$) und einem vierten Transistor (Q$_{10}$), die parallel zwischen der genannten Gatterschaltung und einer zweiten Stromversorgungsleitung verbunden sind, wobei der genannte dritte Transistor als Reaktion auf den Ausgang der genannten Gatterschaltung gesteuert wird und der genannte vierte Transistor als Reaktion auf den Ausgang der genannten Verzögerungsschaltung gesteuert wird.

2. Eine Schaltung nach Anspruch 1, in welcher der genannte Impulsbreitensteuerschaltung (WC) außerdem folgendes umfaßt:

einen Steuerkreis (CNT) mit einem auf den genannten Ausgang der genannten Gatterschaltung (CG) reagierenden Eingangsende und mit einem mit der genannten Halte- und Rücksetzschaltung (Q$_9$, Q$_{10}$) verbundenen Ausgangsende, wobei der genannte Steuerkreis (CNT) die genannte Verzögerungsschaltung zur Übertragung einer Signaländerung an dem genannten Eingangsende zu dem genannten Ausgangsende mit einer vorher festgesetzten Zeitverzögerung umfaßt.

3. Eine Schaltung nach Anspruch 2, außerdem umfassend einen Inverter (Q$_3$, Q$_4$) mit einem Eingangsende, verbunden mit dem genannten Ausgang der genannten Gatterschaltung (CG), und einem Ausgangende, verbunden mit einer Gateelektrode des genannten ersten Transistors (Q$_7$), wobei der genannte zweite Transistor (Q$_8$) eine Gateelektrode hat, die mit dem genannten Ausgangsende des genannten Steuerkreises (CNT) verbunden ist, und wobei der genannte erste und zweite Transistor zwischen einer Stromversorgung und dem genannten Ausgang der genannten Gatterschaltung (CG) in Reihe geschaltet sind.

4. Eine Schaltung nach Anspruch 3, in welcher der genannte dritte Transistor (Q$_9$) eine Gatee-

lektrode hat, die mit dem genannten Ausgangsende des genannten Inverters (Q$_3$, Q$_4$) verbunden ist, und der genannte vierte Transistor (Q$_{10}$) eine Gateelektrode hat, die mit dem genannten Ausgangsende des genannten Steuerkreises (CNT) verbunden ist, wobei der genannte dritte und vierte Transistor zwischen die genannte Gatterschaltung (CG) und eine Masse-Stromversorgung geschaltet sind.

5. Eine Schaltung nach Anspruch 4, in welcher der genannte Steuerkreis (CNT) folgendes umfaßt:

einen ersten Inverter (Q$_{33}$, Q$_{34}$) mit einem Eingangsende, das mit dem genannten Ausgang der genannten Gatterschaltung (CG) verbunden ist;

einen zweiten Inverter (Q$_{31}$, Q$_{32}$) mit einem Eingangsende, das mit dem Ausgangsende des genannten ersten Inverters (Q$_{33}$, Q$_{34}$) verbunden ist, und mit einem Ausgangsende, das mit den Gateelektroden des genannten zweiten Transistors (Q$_8$) und des genannten vierten Transistors (Q$_{10}$) verbunden ist;

einen Widerstand (R), der zwischen den genannten ersten Inverter (Q$_{33}$, Q$_{34}$) und die Masse-Stromversorgung geschaltet ist; und

einen Kondensator (C), der zwischen das Ausgangsende des genannten ersten Inverters (Q$_{33}$,Q$_{34}$) und die Masse-Stromversorgung geschaltet ist;

wobei der genannte Widerstand (R) und der genannte Kondensator (C) die genannte Verzögerungsschaltung bilden.

6. Eine Schaltung nach einem der Ansprüche 1 bis 5, die außerdem eine zusätzliche Impulsgeneratorschaltung (PG$_N$) umfaßt, so angeordnet, daß sie ein Chipansteuersignal ($\overline{CS}$) für die Auswahl des genannten Speichers empfängt.

7. Eine Schaltung nach einem der Ansprüche 1 bis 5, die außerdem eine zusätzliche Impulsgeneratorschaltung (PG$_N$) umfaßt, so angeordnet, daß sie ein Schreibfreigabesignal für die Freigabe einer Schreiboperation der genannten Speichervorrichtung empfängt.

8. Eine Schaltung nach einem der vorstehenden Ansprüche, in der das genannte Taktsignal für das Kurzschließen von Bitleitungspaaren in der genannten Speichervorrichtung verwendet wird.

**Revendications**

1. Un circuit de génération de signal d'horloge d'un dispositif de mémoire à semiconducteurs, comprenant :

un ensemble de circuits de génération d'impulsion (PG$_0$, PG$_1$, ...) ayant chacun une entrée destinée à recevoir un signal d'entrée d'adresse, et ayant chacun une sortie destinée à fournir une impulsion sous l'effet d'un changement du signal d'entrée d'adresse; et

un circuit de portes (CG) ayant un ensemble d'entrées connectées aux sorties des circuits de génération d'impulsion (PG$_0$, PG$_1$, ...) et ayant une sortie qui est destinée à fournir un signal de sortie sous la dépendance des signaux appliqués aux entrées; caractérisé en ce que :

le circuit de portes (CG) comprend un ensemble de portes inverseuses (Q$_{11}$, Q$_{21}$; Q$_{12}$, Q$_{22}$; ... Q$_{1N}$, Q$_{2N}$), chacune d'elles étant formée par un transistor d'entrée respectif (Q$_{21}$, Q$_{22}$, ... Q$_{2N}$) et par un transistor de rappel au potentiel haut respectif (Q$_{11}$, Q$_{12}$, ... Q$_{1N}$) dont les bornes de grille sont connectées à une sortie de l'un respectif des circuits de génération d'impulsion (PG$_0$, PG$_1$, ...), tous les transistors de rappel au potentiel haut étant connectés en commun à la sortie du circuit de portes, et tous les transistors d'entrée étant connectés en série; et en ce que

un circuit de commande de largeur d'impulsion (WC) est incorporé et est connecté fonctionnellement à la sortie du circuit de portes (CG), pour verrouiller le signal de sortie du circuit de portes et pour restaurer ultérieurement cette condition de verrouillage, de façon à étendre la largeur d'impulsion du signal de sortie au moins jusqu'à une largeur prédéterminée; ce circuit de commande de largeur d'impulsion (WC) comprenant :

un circuit de retard qui est destiné à retarder le signal de sortie du circuit de portes (CG); et

un circuit de verrouillage et de restauration (Q$_7$ ... Q$_{10}$) ayant un premier transistor (Q$_7$) et un second transistor (Q$_8$) connectés en série entre une première ligne d'alimentation (V$_{CC}$) et la sortie du circuit de portes, le premier transistor étant commandé sous la dépendance du signal de sortie du circuit de portes (CG), et le second transistor (Q$_8$) étant commandé sous la dépendance du signal de sortie du circuit de retard; et un troisième transistor (Q$_9$) et un quatrième transistor (Q$_{10}$) connectés en parallèle entre le circuit de portes et une seconde ligne d'alimentation, le troisième transistor étant commandé sous la dépendance du signal de sortie du circuit de portes, tandis que le quatrième transistor est commandé sous la dépendance du signal de sortie du circuit de retard.

2. Un circuit selon la revendication 1, dans lequel le circuit de commande de largeur d'impulsion (WC) comprend en outre :

un circuit de commande (CNT) ayant un noeud d'entrée qui réagit au signal de sortie du circuit de portes (CG), et ayant un noeud de sortie qui est connecté au circuit de verrouillage et de restauration (Q$_9$, Q$_{10}$), ce circuit de commande (CNT) comprenant le circuit de retard précité qui est destiné à transférer un changement de signal du noeud d'entrée vers le noeud de sortie avec un retard prédéterminé.

3. Un circuit selon la revendication 2, comprenant en outre un inverseur (Q$_3$, Q$_4$) ayant un noeud d'entrée, connecté à la sortie du circuit de portes (CG), et un noeud de sortie, connecté à une électrode de grille du premier transistor (Q$_7$), et dans lequel le second transistor (Q$_8$) a une électrode de grille qui est connectée au noeud de sortie du circuit de commande (CNT), les premier et second transistors étant connectés en série entre une alimentation et la sortie du circuit de portes (CG).

4. Un circuit selon la revendication 3, dans lequel le troisième transistor (Q$_9$) a une électrode de grille qui est connectée au noeud de sortie de l'inverseur (Q$_3$, Q$_4$), et le quatrième transistor (Q$_{10}$) a une électrode de grille qui est connectée au noeud de sortie du circuit de commande (CNT), les troisième et quatrième transistors étant connectés entre le circuit de portes (CG) et une borne d'alimentation correspondant à la masse.

5. Un circuit selon la revendication 4, dans lequel le circuit de commande (CNT) comprend :

un premier inverseur (Q$_{33}$, Q$_{34}$) ayant une borne d'entrée connectée à la sortie du circuit de portes (CG); un second inverseur (Q$_{31}$, Q$_{32}$) ayant un noeud d'entrée connecté au noeud de sortie du premier inverseur (Q$_{33}$, Q$_{34}$) et ayant un noeud de sortie connecté aux électrodes de grille du second transistor (Q$_8$) et du quatrième transistor (Q$_{10}$);

une résistance (R) connectée entre le premier inverseur (Q$_{33}$, Q$_{34}$) et la borne d'alimentation correspondant à la masse; et

un condensateur (C) connecté entre le noeud de sortie du premier inverseur (Q$_{33}$, Q$_{34}$) et la borne d'alimentation correspondant à la masse;

la résistance (R) et le condensateur (C) formant le circuit de retard précité.

6. Un circuit selon l'une quelconque des revendications 1 à 5, comprenant en outre un circuit de génération d'impulsion supplémentaire (PG$_n$) qui est conçu de façon à recevoir un signal de sélection de puce ($\overline{CS}$) pour sélectionner le dispositif de mémoire.

7. Un circuit selon l'une quelconque des revendications 1 à 5, comprenant en outre un circuit de génération d'impulsion supplémentaire (PG$_n$) qui est conçu pour recevoir un signal de validation d'écriture destiné à autoriser une opération d'écriture du dispositif de mémoire.

8. Un circuit selon l'une quelconque des revendications précédentes, dans lequel le signal d'horloge est utilisé pour court-circuiter des paires de lignes de bit dans le dispositif de mémoire.

# Fig. 1

# Fig. 2

# Fig. 3

Fig.4A  $\phi_0$
Fig.4B  $\phi_1$
Fig.4C  ①
Fig.4D  ②
Fig.4E  ③
Fig.4F  ④

# *Fig. 5*

<u>PG</u>

# *Fig. 6*

C S